# EUROPÄISCHE PATENTANMELDUNG

(11) **EP 2 257 146 A2**
(43) Veröffentlichungstag der Anmeldung: **01.12.2010**
(21) Anmeldenummer: 10163866.6
(22) Anmeldetag: 26.05.2010
(51) Int. Cl.: H05K 7/20, H02B 1/56

(54) **Wechselrichtergebäude**

(30) Priorität: 27.05.2009 DE 202009007559 U
(71) Anmelder: voltwerk electronics GmbH, 20537 Hamburg (DE)
(72) Erfinder: Elster, Steffen, 22767, Hamburg (DE); Fischer, Lars, 22307, Hamburg (DE)
(74) Vertreter: Eisenführ, Speiser & Partner

(57) **Zusammenfassung**

Die Erfindung betrifft ein Gebäude zur Aufnahme Abwärme erzeugender elektrischer Geräte, insbesondere ein Wechselrichtergebäude, umfassend einen Lufteinlass, einen Luftauslass, einen in Strömungsrichtung hinter dem Lufteinlass liegenden Zuluftkanal und mindestens eine Lüftervorrichtung zum Erzeugen einer Luftströmung vom Lufteinlass zum Luftauslass. Erfindungsgemäß erstreckt sich der Zuluftkanal von der Einlassöffnung zu einem unterhalb der Einlassöffnung liegenden unteren Strömungsraum und die Lüftervorrichtung ist in dem unteren Strömungsraum angeordnet.

## Beschreibung

Die Erfindung betrifft ein Gebäude zur Aufnahme Abwärme erzeugender elektrischer Geräte, insbesondere ein Wechselrichtergebäude, umfassend einen Lufteinlass, einen Luftauslass, einen in Strömungsrichtung hinter dem Lufteinlass liegenden Zuluftkanal und mindestens eine Lüftervorrichtung zum Erzeugen einer Luftströmung vom Lufteinlass zum Luftauslass.

Gebäude zur Aufnahme Abwärme erzeugender elektrischer Geräte werden teilweise auch als Technikstationen bezeichnet und sind häufig begehbar ausgebildet, können aber auch als kleinere Kompaktstationen ausgebildet sein. Die Gebäude können beispielsweise als Beton-, Mauerwerk- oder Verbundkonstruktionen oder als Containerstationen ausgeführt sein. Die Gebäude können im Betriebszustand ebenerdig oder beispielsweise auf dem Dach einer Anlage bzw. eines anderen Gebäudes aufgestellt sein.

Die eingangs genannten Gebäude kommen in unterschiedlichen Anwendungsgebieten zum Einsatz, zum Beispiel als Wechselrichtergebäude für das Einspeisen beispielsweise in Photovoltaik- oder Windenergieanlagen gewonnener Energie in das öffentliche Stromnetz oder als Transformatorenstationen.

Die in einem Gebäude aufgenommenen elektrischen Geräte, wie beispielsweise Wechselrichter oder Transformatoren, erzeugen Abwärme, weshalb das Gebäude ausreichend be- und entlüftet werden muss. Das Gebäude weist hierzu einen Lufteinlass und einen Luftauslass auf. Neben Luftein- und -auslass kann das Gebäude andere, verschließbare Öffnungen wie beispielsweise Türen, Fenster oder Versorgungsschächte aufweisen.

Es ist erforderlich, dass die zur Be- und Entlüftung vom Lufteinlass zum Luftauslass durch das Gebäude strömende Luft möglichst frei von Fremdstoffen und/oder Verunreinigungen, wie beispielsweise Staub, Pollen oder anderen Partikeln, ist, um die in dem Gebäude angeordneten elektrischen Geräte und ihre Komponenten nicht zu verunreinigen. Solche Verunreinigungen können zu einem vorzeitigen bzw. verstärkten Verschleiß, Beschädigungen und/oder sogar zum Ausfall der elektrischen Geräte führen.

Für eine ausreichende Lüftung der Gebäude können Luftmengen von mehreren 100 m³ pro Stunde erforderlich sein. Gleichzeitig ist die Luftführung oft beispielsweise wegen der möglichst geringen Baugröße der Gebäude und/oder der Anordnung der Geräte im Gebäude hinsichtlich der Luftströmung nicht optimal. Weiterhin können sowohl im Gebäude angeordnete Komponenten, wie Filter, Lamellen oder Prallbleche, als auch externe Faktoren, wie Witterungseinflüsse, insbesondere wechselnder Winddruck, den Volumenstrom der Luft im Gebäude nachteilig beeinflussen.

Zwar weisen die in den Gebäuden angeordneten elektrischen Geräte oft eingebaute Lüfter auf, jedoch reichen diese zur Sicherstellung einer ausreichenden Luftströmung im Gebäude meist nicht aus. Gebäude der eingangs genannten Art weisen daher mindestens eine separate, das heißt dem Gebäude und nicht einem Gerät zugehörige Lüftervorrichtung, beispielsweise einen Ventilator oder ein Gebläse, zum Erzeugen einer Luftströmung vom Lufteinlass zum Luftauslass auf, um einen ausreichenden Volumenstrom zur Abführung der Abwärme der elektrischen Geräte zu erreichen.

Existierende Gebäude der eingangs genannten Art weisen jedoch Nachteile in verschiedener Hinsicht auf. Schallemissionen, die insbesondere von der Lüftervorrichtung verursacht werden, belasten die Umgebung der Gebäude. Weiterhin kommt es bei existierenden Gebäuden häufig noch zu Verunreinigungen der Luft und damit zu vorzeitigem bzw. verstärktem Verschleiß, Beschädigungen bzw. dem Ausfall der elektrischen Geräte. Dies führt einerseits zu hohen Wartungs- und Instandsetzungskosten für die Geräte und weiterhin zu Ausfallkosten, wenn die Geräte nicht einsatzfähig sind.

Ein weiterer Nachteil existierender Gebäude ist es, dass eine Wartung bzw. ein Wechsel der Filtereinrichtung häufig nur möglich ist, wenn die Lüftervorrichtung und/oder die Abwärme erzeugenden elektrischen Geräte außer Betrieb genommen werden. Insbesondere wenn ein Kontakt mit der Lüftervorrichtung und/oder den Abwärme erzeugenden elektrischen Geräten bei Arbeiten an der Filtereinrichtung nicht ausgeschlossen werden kann, können weiterhin die Arbeiten am Filter nur durch Elektrofachkräfte bzw. entsprechend eingewiesene Personen ausgeführt werden.

Es ist daher die Aufgabe der vorliegenden Erfindung, ein Gebäude zur Aufnahme Abwärme erzeugender elektrischer Geräte, insbesondere ein Wechselrichtergebäude, bereitzustellen, das einen oder mehrere der genannten Nachteile vermindert oder beseitigt.

Diese Aufgabe wird gelöst durch ein Gebäude der eingangs genannten Art, das dadurch gekennzeichnet ist, dass sich der Zuluftkanal von der Einlassöffnung zu einem unterhalb der Einlassöffnung liegenden unteren Strömungsraum erstreckt und die Lüftervorrichtung in dem unteren Strömungsraum angeordnet ist.

In dem erfindungsgemäßen Gebäude befindet sich die Lüftervorrichtung beabstandet von der Einlassöffnung in einem unteren Strömungsraum des Zuluftkanals. Der Zuluftkanal erstreckt sich vorzugsweise von der Einlassöffnung zu dem unterhalb der Einlassöffnung liegenden unteren Strömungsraum und zu den Abwärme erzeugenden elektrischen Geräten. Zwischen Luftauslass und den Abwärme erzeugenden elektrischen Geräten erstreckt sich vorzugsweise ein Abluftkanal.

Durch die im unteren Strömungsraum angeordnete mindestens eine Lüftervorrichtung wird eine Luftströmung erzeugt, die vorzugsweise durch den Lufteinlass in das Gebäude eintritt, den Zuluftkanal durchströmt, die Abwärme erzeugenden elektrischen Geräte durch- und/oder umströmt, den Abluftkanal durchströmt und durch den Luftauslass wieder aus dem Gebäude austritt.

Das erfindungsgemäße Gebäude kann ein, zwei oder mehrere Lüftervorrichtungen aufweisen. Art und Anzahl der Lüftervorrichtungen werden vorzugsweise in Abhängigkeit von Größe, Konstruktion, Art und/oder Anzahl der Abwärme erzeugenden elektrischen Geräte sowie der Geometrie der Luftführung bestimmt. Die zuvor und im folgenden beschriebenen Merkmale, Ausgestaltungen und Vorteile einer Lüftervorrichtung gelten entsprechend auch für zwei oder mehrere Lüftervorrichtungen eines erfindungsgemäßen Gebäudes.

Die erfindungsgemäße Anordnung der Lüftervorrichtung in dem unteren Strömungsraum hat mehrere Vorteile. Der Erfindung liegt zum einen die Erkenntnis zugrunde, dass die bei den existierenden Gebäuden im Stand der Technik häufig auftretenden hohen Schallemissionen ihren Grund meist darin haben, dass die Lüftervorrichtungen nahe dem Luftein- oder -auslass angeordnet sind und der von der Lüftervorrichtung erzeugte Schall durch diese Öffnungen mehr oder weniger ungedämpft nach außen treten kann. Damit wird zwar die Wartung der Lüftervorrichtung erleichtert, aber zur Vermeidung hoher Schallemissionen eine aufwendige akustische Dämpfung erforderlich. Diese wiederum erhöht den Strömungswiderstand und erfordert daher mehr Energieansatz. Insbesondere wenn die Lüftervorrichtung im Abluftkanal zwischen den Abwärme erzeugenden elektrischen Geräten und dem Luftauslass angeordnet ist, wird der Schall mehr oder weniger ungedämpft mit der Abluft durch den Luftauslass nach außen abgegeben. Durch die erfindungsgemäße Anordnung der Lüftervorrichtung in einem unteren Strömungsraum kann der Abstand der Lüftervorrichtung von Luftein- und Luftauslass vergrößert und damit die Schallemission deutlich reduziert werden.

Die erfindungsgemäße Beabstandung der Lüftervorrichtung von Luftein- und -auslass und/oder einer Filtereinrichtung hat weiterhin den Vorteil, dass die Lüftervorrichtung nicht direkt mit der Umgebung und/oder einer Filtereinrichtung in Verbindung steht und auf diese Weise die Leistung der Lüftervorrichtung weniger stark von Witterungseinflüssen, insbesondere dem Winddruck, bzw. dem Verunreinigungsgrad einer Filtereinrichtung abhängig ist.

Ein weiterer Vorteil der erfindungsgemäßen Positionierung der Lüftervorrichtung in dem unteren Strömungsraum besteht darin, dass die Lüftervorrichtung auf diese Weise nicht direkt hinter bzw. am Lufteinlass sondern vom Lufteinlass beabstandet angeordnet ist. Durch diese erfindungsgemäße Beabstandung der Lüftervorrichtung vom Lufteinlass ist es beispielsweise möglich, am Lufteinlass angeordnete Filtereinrichtungen zu prüfen, zu warten und/oder auszutauschen, ohne die Lüftervorrichtung abschalten und/oder demontieren zu müssen.

Ein weiterer Vorteil besteht in einem besseren Schutz vor Verunreinigungen der elektrischen Geräte. Auch bei Gebäuden im Stand der Technik, die Filtereinrichtungen aufweisen, können dennoch Verunreinigungen in den Luftstrom gelangen. Diese Verunreinigungen können ihre Ursache beispielsweise in falsch eingesetzten, beschädigten und/oder zu stark verunreinigten Filtereinrichtungen haben oder beispielsweise beim Austausch der Filtereinrichtungen entstehen, wenn Arbeitsmaterialien, Abfälle und/oder sonstige Teile in das Innere des Gebäudes, insbesondere in den Zuluftkanal, gelangen. Ein Vorteil der Erfindung ergibt sich unter anderem dadurch, dass der Strömungsraum mit der Lüftervorrichtung unterhalb der Einlassöffnung angeordnet ist. Auf diese Weise können durch den Lufteinlass eingetretene Schmutz- bzw. Staubpartikel und/oder Verunreinigungen anderer Art zunächst durch Gravitation nach unten in den Strömungsraum gelangen und sich dort zumindest teilweise außerhalb des Luftstroms sammeln. Im Gegensatz zu den im Stand der Technik meist direkt hinter dem Lufteinsatz angeordneten Lüfterrrorrichtungen, die eintretende Verunreinigungen direkt im Luftstrom weiterbefördern, kann mit der erfindungsgemäßen Anordnung der Lüftervorrichtung im unteren Strömungsraum zumindest teilweise verhindert werden, dass Verunreinigungen direkt zu den elektrischen Geräten transportiert werden. Auf diese Weise kann die Verunreinigung der elektrischen Geräte in vorteilhafter Weise reduziert werden.

Die Erfindung kann dadurch fortgebildet werden, dass das Gebäude einen Geräteabschnitt und einen unterhalb des Geräteabschnitts angeordneten Bodenabschnitt aufweist, wobei der untere Strömungsraum in dem Bodenabschnitt des Gebäudes angeordnet ist.

Im Geräteabschnitt des erfindungsgemäßen Gebäudes sind vorzugsweise die Abwärme erzeugenden Geräte angeordnet. Der darunter befindliche Bodenabschnitt weist den unteren Strömungsraum auf. Im Bodenabschnitt eines erfindungsgemäßen Gebäudes können beispielsweise auch Kabelschächte, sonstige Leitungsvorrichtungen und/oder weitere (Versorgungs-)Komponenten angeordnet sein. Die Ausbildung eines Geräteabschnitts und eines Bodenabschnitts hat den Vorteil, dass diese Abschnitte beispielsweise aus ganz oder teilweise unterschiedlichen Materialien ausgebildet sein können. Dabei ist es bevorzugt, den Bodenabschnitt beispielsweise aus einem Material mit erhöhten Schalldämpfungseigenschaften auszubilden, um die durch die Lüftervorrichtung verursachten Schallemissionen weiter zu reduzieren. Besonders bevorzugt ist beispielsweise eine Ausbildung des Bodenabschnitts aus Normalbeton und eine Ausbildung des Geräteabschnitts aus Leichtbeton, Mauerwerk oder als Verbundkonstruktion.

Die Erfindung kann dadurch fortgebildet werden, dass der Bodenabschnitt vom Geräteabschnitt mindestens abschnittweise durch eine im Wesentlichen horizontale Standfläche zur Aufstellung der Abwärme erzeugenden elektrischen Geräte getrennt ist. Die Trennung von Bodenabschnitt und Geräteabschnitt durch eine Standfläche, auf der die Abwärme erzeugenden elektrischen Geräte direkt oder auf dafür vorgesehenen Konstruktionen aufgestellt bzw. angeordnet sind, dient ebenfalls unter anderem dazu, die Weitergabe des durch die Lüftervorrichtung erzeugten Schalls zu vermindern. Weiterhin hat diese erfindungsgemäße Fortbildung den Vorteil, dass durch die Standfläche die im Bodenabschnitt angeordneten Komponenten abgedeckt und dadurch einerseits geschützt und andererseits beim Betreten des Gebäudes nicht hinderlich sind.

Die Erfindung kann dadurch fortgebildet werden, dass der Bodenabschnitt des Gebäudes im Betriebszustand des Gebäudes ganz oder teilweise unterhalb der Erdoberfläche angeordnet ist. Besonders bei erfindungsgemäßen Gebäuden, die im Betriebszustand ebenerdig angeordnet sind, ist es bevorzugt, den Bodenabschnitt des Gebäudes ganz oder teilweise als unterhalb der Erdoberfläche angeordneten Kellerabschnitt auszubilden. Neben Vorteilen für die Standsicherheit des Gebäudes kann auf diese Weise der in die Umgebung abgegebene Schall der Lüftervorrichtung weiter deutlich reduziert werden.

Die Erfindung kann dadurch fortgebildet werden, dass der Lufteinlass und/oder der Luftauslass in dem Geräteabschnitt des Gebäudes angeordnet ist bzw. sind, vorzugsweise in der oberen Hälfte des Geräteabschnitts. Durch die Anordnung von Lufteinlass und/oder Luftauslass im Geräteabschnitt einerseits und der Lüftervorrichtung im Bodenabschnitt andererseits wird in vorteilhafterweise ein möglichst großer Abstand zwischen Lufteinlass bzw. Luftauslass und der Lüftervorrichtung erzielt. Auf diese Weise kann das Austreten des von der Lüftervorrichtung erzeugten Schalls durch den Lufteinlass und/oder den Luftauslass weiter verringert werden. Insbesondere bevorzugt ist es, den Lufteinlass und/oder Luftauslass in der oberen Hälfte des Geräteabschnitts vorzugsweise im Dach des Gebäudes anzuordnen und/oder Lufteinlass bzw. Luftauslass so anzuordnen, dass der Luftströmungsweg zwischen Lufteinlass bzw. Luftauslass und Lüftervorrichtung möglichst groß ist.

Weiterhin kann auf diese Weise die Beeinflussung der Lüftervorrichtung durch Winddruck und/oder den Verunreinigungsgrad einer am Lufteinlass angeordneten Filtereinrichtung reduziert werden.

Die Erfindung wird vorzugsweise fortgebildet durch eine Filtereinrichtung, die vorzugsweise am Lufteinlass angeordnet ist. Die Erfindung kann weiter dadurch fortgebildet werden, dass die Filtereinrichtung derart angeordnet ist, dass sie von außerhalb des Gebäudes auswechselbar ist.

Im erfindungsgemäßen Gebäude wird eine Filtereinrichtung zum Verhindern des Eintretens von Verunreinigungen in das Gebäude, insbesondere in den Zuluftkanal, vorzugsweise am Lufteinlass angeordnet. Dadurch kann einerseits in vorteilhafter Weise erreicht werden, dass Verunreinigungen gar nicht erst in das Innere des Gebäudes gelangen, sondern direkt am Lufteinlass abgefangen werden. Weiterhin bietet diese Anordnung der Filtereinrichtung den Vorteil, dass ein Betreten des Gebäudes zum Prüfen, Warten oder Auswechseln nicht erforderlich ist, sondern die Filtereinrichtung hierzu von außen zugängig ist. Wenn ein Betreten des Gebäudes nicht erforderlich ist, müssen auch die elektrischen Geräte im Gebäude für Arbeiten am Filter nicht abgeschaltet werden, wodurch die Ausfallzeiten reduziert werden können.

Die erfindungsgemäße Anordnung der Filtereinrichtung am Lufteinlass einerseits und der Lüftervorrichtung im unteren Strömungsraum andererseits hat weiterhin den Vorteil, dass auch Personen, die im Umgang mit elektrischen Geräten nicht geschult sind, Arbeiten am Filter vornehmen können, da aufgrund dieser Anordnung bei Arbeiten am Filter bzw. beim Filtertausch kein Kontakt mit der Lüftervorrichtung möglich bzw. erforderlich und auch ein Betreten des Gebäudes nicht erforderlich ist. Auch eine Abschaltung und/oder Demontage der Lüftervorrichtung ist nicht erforderlich. Dies erleichtert und verkürzt einerseits die Arbeiten zur Prüfung, Wartung bzw. Tausch des Filters und erhöht andererseits die Verfügbarkeit der im Gebäude angeordneten elektrischen Geräte.

Die Erfindung kann durch eine im Zuluftkanal angeordnete Fremdstoffauffangeinrichtung fortgebildet werden. Eine erfindungsgemäß im Zuluftkanal angeordnete Fremdstoffauffangeinrichtung hat den Vorteil, dass durch den Lufteinlass in den Zuluftkanal gelangte Verunreinigungen - beispielsweise durch fehlende, falsch eingesetzte, defekte oder zu stark verunreinigte Filtereinrichtungen - aufgefangen werden können, bevor diese mit dem Luftstrom zu den elektrischen Geräten transportiert werden und die Geräte verunreinigen und damit gegebenenfalls beschädigen können.

Die Fremdstoffauffangeinrichtung kann beispielsweise eine Gitter- oder Blechkonstruktion sein, die geeignet ist, Verunreinigungen aus dem Luftstrom ganz oder teilweise zu entfernen. Vorzugsweise kann die Fremdstoffauffangeinrichtung ausgewechselt und/oder gereinigt werden.

Die Erfindung kann dadurch fortgebildet werden, dass die Fremdstoffauffangeinrichtung zumindest abschnittsweise im unteren Strömungsraum angeordnet ist. Diese Anordnung ist besonders bevorzugt, da auf diese Weise Fremdstoffe vom Lufteinlass durch Gravitation in den unterhalb der Einlassöffnung liegenden unteren Strömungsraum gelangen und dort von der Fremdstoffauffangeinrichtung aufgefangen werden können.

Die Erfindung kann dadurch fortgebildet werden, dass die Fremdstoffauffangeinrichtung im Zuluftkanal zwischen der Lüftereinrichtung und dem Lufteinlass angeordnet ist. Vorzugsweise ist die Fremdstoffauffangeinrichtung zwischen dem Lufteinlass und der Lüftereinrichtung angeordnet. Auf diese Weise kann eine Verunreinigung der Lüftereinrichtung vermindert bzw. vermieden werden, da durch den Lufteinlass eingetretene Verunreinigungen bzw. Fremdstoffe von der Fremdstoffauffangeinrichtung aufgefangen werden können, bevor sie zur Lüftereinrichtung gelangen.

Die Erfindung kann dadurch fortgebildet werden, dass die Fremdstoffauffangeinrichtung ein im Wesentlichen horizontal angeordnetes Gitter aufweist. Ein solches Gitter ist insbesondere vorteilhaft, um beispielsweise größere Fremdstoffe aufzufangen, die beispielsweise die Lüftereinrichtung und/oder die elektrischen Geräte beschädigen könnten. Solche größeren Fremdstoffe können beispielsweise Steine oder bei einem Filterwechsel versehentlich in den Zuluftkanal gelangte Filterteile sein.

Die Erfindung kann dadurch fortgebildet werden, dass die Fremdstoffauffangeinrichtung eine Sammeleinrichtung aufweist, die ausgebildet ist, eingetretene Fremdstoffe zurückzuhalten, und vorzugsweise unterhalb des Gitters angeordnet ist. Eine Sammeleinrichtung bewirkt in vorteilhafter Weise, dass die in der Fremdstoffauffangeinrichtung aufgefangenen Fremdstoffe bzw. Verunreinigungen zumindest teilweise nicht wieder in die Luftströmung gelangen, sondern zumindest größtenteils in der Sammeleinrichtung verbleiben, bis die Fremdstoffauffangeinrichtung als ganzes oder nur die Sammeleinrichtung ausgetauscht bzw. gereinigt und die Verunreinigung bzw. Fremdstoffe auf diese Weise aus dem Gebäude entfernt werden. Vorzugsweise ist die Sammeleinrichtung unterhalb des Gitters angeordnet, da auf diese Weise nur die kleineren, das Gitter passierenden Fremdstoffe bzw. Verunreinigungen in die Sammeleinrichtung gelangen können. Auf diese Weise kann verhindert werden, dass die Sammeleinrichtung durch besonders große Fremdstoffe blockiert oder evtl. sogar beschädigt wird.

Die Erfindung kann dadurch fortgebildet werden, dass die Sammeleinrichtung ganz oder abschnittsweise unterhalb der Lüftervorrichtung angeordnet ist. Diese erfindungsgemäße Anordnung nutzt in vorteilhafterweise die Gravitationswirkung, so dass die in der Sammeleinrichtung befindlichen Fremdstoffe unterhalb der Lüftereinrichtung angeordnet sind und durch die von der Lüftervorrichtung erzeugte Luftströmung zunächst wieder angehoben werden müssten, um von der Luftströmung mitgetragen zu werden. Die Anordnung der Sammeleinrichtung unterhalb der Lüftereinrichtung erschwert diese Aufnahme der Verunreinigungen in die Luftströmung und verbessert somit die Rückhaltefunktion der Sammeleinrichtung.

Die Erfindung kann weiterhin durch mindestens ein Luftleitblech, das derart angeordnet ist, dass es die Luftströmung vom Lufteinlass zum Luftauslass unterstützt, fortgebildet werden. Erfindungsgemäße Gebäude sind meist platzsparend konstruiert, so dass die Führung der Kanäle zur Be- und Entlüftung häufig nicht hinsichtlich der Strömungseigenschaften optimiert werden kann. Daher ist es vorteilhaft, die Strömung durch Luftleitbleche zu verbessern. Gleichzeitig oder alternativ ist es bevorzugt, die Luftleitbleche derart anzuordnen, dass die Schallemissionen verringert werden.

Die Erfindung kann weiterhin durch mindestens ein Prallblech, das derart angeordnet ist, dass es eine Leitung von Fremdstoffen in Richtung der Fremdstoffauffangeinrichtung unterstützt, fortgebildet werden. Im erfindungsgemäßen Gebäude werden Fremdstoffe bzw. Verunreinigungen vorzugsweise im wesentlichen durch Gravitation vom Lufteinlass zur Fremdstoffauffangeinrichtung transportiert. Es ist jedoch bevorzugt, diesen Transport durch Prallbleche oder ähnliche Einrichtungen zu unterstützen.

Eine bevorzugte Ausführungsform wird beispielhaft anhand der beiliegenden Figur beschrieben. Es zeigt:

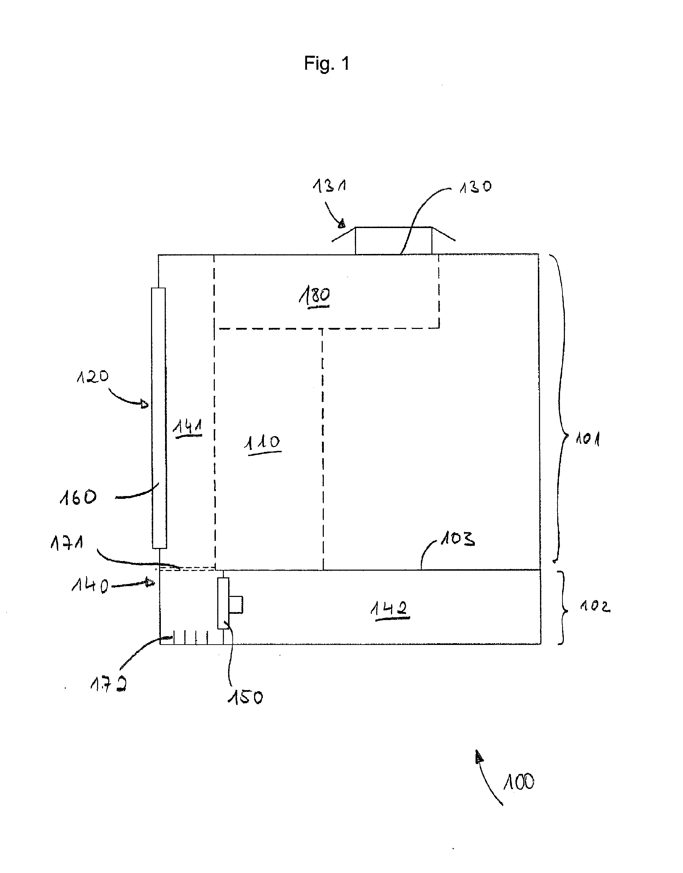

- Fig. 1: einen Querschnitt durch eine schematische Darstellung eines erfin- dungsgemäßen Gebäudes zur Aufnahme Abwärme erzeugende elektrische Geräte.

Die in Fig. 1 gezeigte Ausführungsform des erfindungsgemäßen Gebäudes ist ein Wechselrichtergebäude, in dem ein bzw. mehrere Wechselrichter 110 angeordnet ist bzw. sind.

Das erfindungsgemäße Wechselrichtergebäude 100 weist einen Lufteinlass 120 und einen Luftauslass 130 auf. Am Lufteinlaß 120 ist eine Filtereinrichtung 160 bestehend aus Filtermatten angeordnet. Hinter dem Lufteinlass 120 mit der Filtereinrichtung 160 grenzt ein Zuluftkanal 140 an, der einen Bereich 141 direkt hinter dem Lufteinlass 130 aufweist und sich zu einem unterhalb der Einlassöffnung 120 liegenden unteren Strömungsraum 142 erstreckt.

Der Luftauslass 130 ist durch eine Ablufthaube 131 gegen das Eintreten von Verunreinigungen und/oder Wasser geschützt. An den Luftauslass grenzt ein Abluftkanal 180 an.

Die Wechselrichter 110 sind auf einer Standfläche 103 angeordnet. Die Standfläche 103 trennt einen Bodenabschnitt 102 von einem Geräteabschnitt 101 des Wechselrichtergebäudes 100. Der Bodenabschnitts 102 ist vorzugsweise aus Normalbeton, der Geräteabschnitts 101 aus Leichtbeton, Mauerwerk oder als Verbundkonstruktion ausgebildet. Der Geräteabschnitt 101 dient dazu, die Abwärme erzeugenden elektrischen Geräte, hier die Wechselrichter 110, aufzunehmen. Im Bodenabschnitt 102 sind in der in Fig. 1 gezeigten Ausführungsform ein unterer Strömungsraum 142, mindestens eine Lüftervorrichtung 150 sowie eine Fremdstoffauffangeinrichtung bestehend aus einem Schutzgitter 171 und einer als Schmutzfang ausgebildeten Sammeleinrichtung 172 angeordnet.

Die Wechselrichter 110 können integrierte Lüfter (nicht dargestellt) aufweisen. Diese reichen jedoch in der Regel nicht aus, um die erforderliche Luftströmung vom Lufteinlass 120 zum Luftauslass 130 zu erzeugen. Die erforderliche Luftströmung vom Lufteinlass 120 zum Luftauslass 130 wird durch die im unteren Strömungsraum 142 angeordnete mindestens eine Lüftervorrichtung 150 erzeugt.

Zwischen dem Lufteinlass 120 mit der Filtereinrichtung 160 und der Lüftervorrichtung 150 ist eine Fremdstoffauffangeinrichtung mit einem Schutzgitter 171 und einer als Schmutzfang 172 ausgebildeten Sammelvorrichtung angeordnet. Sollten durch den Lufteinlass 120 Fremdstoffe bzw. Verunreinigungen in den Zuluftkanal 140, 141 eintreten - was beispielsweise bei fehlender, defekter, falsch eingebauter oder stark verunreinigter Filtereinrichtung 160 sowie beim Filterwechsel der Fall sein kann - so gelangen diese Verunreinigungen bzw. Fremdstoffe durch Schwerkrafteinwirkung zur Fremdstoffauffangeinrichtung. Dort werden zunächst grobe Fremdstoffe durch das Schutzgitter 171 aufgefangen. Durch das Schutzgitter 171 weiter nach unten in den Strömungsraum 142 gelangende Partikel werden durch die Sammeleinrichtung 172 aufgenommen und zurückgehalten. Die Lüftervorrichtung 150 ist oberhalb der Sammeleinrichtung 172 angeordnet, so dass die durch die Lüftervorrichtung 150 erzeugte Luftströmung die in der Sammeleinrichtung 172 befindlichen Partikel nicht wieder aufwirbelt und somit nicht in die zu den Wechselrichtern 110 führende Luftströmung aufnimmt. Auf diese Weise wird eine Verunreinigung der Wechselrichter 110 und ihrer Komponenten verhindert bzw. verringert. Damit können auch die entsprechenden Nachteile, wie beispielsweise höherer Verschleiß, Beschädigungen oder Ausfall der Wechselrichter, reduziert werden.

Die durch die Lüftervorrichtung 150 erzeugte Luftströmung durchströmt bzw. umströmt die Wechselrichter 110 und strömt anschließend durch den Abluftkanal 180 und den Luftauslass 130 aus dem Wechselrichtergebäude 100 heraus. Da im erfindungsgemäßen Wechselrichtergebäude 100 die Lüftervorrichtung 150 im Bodenabschnitt 102 und nicht im Geräteabschnitt 101, insbesondere nicht in der Nähe des Lufteinlasses 120 oder des Luftauslasses 130, angeordnet ist, kann die Schallemission gegenüber im Stand der Technik bekannten Gebäuden erheblich reduziert werden.

Weiterhin verringert die erfindungsgemäße Anordnung der Lüftervorrichtung 150 die Abhängigkeit der Luftströmung vom Verunreinigungsgrad der Filteeinrichtung 160 und von Witterungseinflüssen, insbesondere Winddruck, da die Lüftungseinrichtung 150 sowohl von Lufteinlass 120 mit der Filtereinrichtung 160 als auch von Luftauslass 130 deutlich beabstandet ist.

Weiterhin weist die erfindungsgemäße Anordnung der Komponenten des Wechselrichtergebäudes 100 den Vorteil auf, dass die Filtereinrichtung 160 von außerhalb des Wechselrichtergebäudes 100 geprüft, gewartet und bei Bedarf ausgewechselt werden kann. Hierzu ist weder ein Betreten der Wechselrichterstation 100 noch ein Abschalten der Lüftervorrichtung 150 und/oder der Wechselrichter 110 erforderlich. Durch die Beabstandung der Lüftervorrichtung 150 sowie der Wechselrichter 110 vom Lufteinlass 120 und der darin angeordneten Filtereinrichtung 160 ist der Kontakt mit den Wechselrichtern 110 und/oder der Lüftervorrichtung 150 von außen weder erforderlich noch möglich, so dass die Arbeiten am Filter 160 auch von Personen ohne besondere Kenntnisse in Bezug auf elektrische Geräte vorgenommen werden können. Dadurch, dass weder die elektrischen Geräte 110 noch die Lüftervorrichtung 150 während der Arbeiten an der Filtereinrichtung 160 abgeschaltet werden müssen, können weiterhin die Ausfallzeiten der elektrischen Geräte 110 reduziert werden.

## Patentansprüche

1. Gebäude (100) zur Aufnahme Abwärme erzeugender elektrischer Geräte (110), insbesondere Wechselrichtergebäude, umfassend
- einen Lufteinlass (120),
- einen Luftauslass (130),
- einen in Strömungsrichtung hinter dem Lufteinlass liegenden Zuluftkanal (140),
- mindestens eine Lüftervorrichtung (150) zum Erzeugen einer Luftströmung vom Lufteinlass zum Luftauslass,
**dadurch gekennzeichnet, dass** sich der Zuluftkanal von der Einlassöffnung zu einem unterhalb der Einlassöffnung liegenden unteren Strömungsraum (142) erstreckt und die Lüftervorrichtung in dem unteren Strömungsraum angeordnet ist.

2. Gebäude (100) nach dem vorhergehenden Anspruch,
**dadurch gekennzeichnet, dass** das Gebäude einen Geräteabschnitt (101) und einen unterhalb des Geräteabschnitts angeordneten Bodenabschnitt (102) aufweist, wobei der untere Strömungsraum (142) in dem Bodenabschnitt des Gebäudes angeordnet ist.

3. Gebäude (100) nach dem vorhergehenden Anspruch,
**dadurch gekennzeichnet, dass** der Bodenabschnitt (102) vom Geräteabschnitt (101) mindestens abschnittweise durch eine im Wesentlichen horizontale Standfläche (103) zur Aufstellung der Abwärme erzeugenden elektrischen Geräte (110) getrennt ist.

4. Gebäude (100) nach einem der beiden vorhergehenden Ansprüche,
**dadurch gekennzeichnet, dass** der Bodenabschnitt (102) des Gebäudes im Betriebszustand des Gebäudes ganz oder teilweise unterhalb der Erdoberfläche angeordnet ist.

5. Gebäude (100) nach einem der drei vorhergehenden Ansprüche,
**dadurch gekennzeichnet, dass** der Lufteinlass (120) und/oder der Luftauslass (130) in dem Geräteabschnitt (101) des Gebäudes angeordnet ist bzw. sind, vorzugsweise in der oberen Hälfte des Geräteabschnitts.

6. Gebäude (100) nach einem der vorhergehenden Ansprüche,
**gekennzeichnet durch** eine Filtereinrichtung (160), die vorzugsweise am Lufteinlass (120) angeordnet ist.

7. Gebäude (100) nach dem vorhergehenden Anspruch,
**dadurch gekennzeichnet, dass** die Filtereinrichtung (160) derart angeordnet ist, dass sie von außerhalb des Gebäudes auswechselbar ist.

8. Gebäude (100) nach einem der vorhergehenden Ansprüche,
**gekennzeichnet durch** eine im Zuluftkanal (140) angeordnete Fremdstoffauffangeinrichtung (171, 172).

9. Gebäude (100) nach dem vorhergehenden Anspruch,
**dadurch gekennzeichnet, dass** die Fremdstoffauffangeinrichtung (171, 172) zumindest abschnittsweise im unteren Strömungsraum (142) angeordnet ist.

10. Gebäude (100) nach einem der beiden vorhergehenden Ansprüche, **dadurch gekennzeichnet, dass** die Fremdstoffauffangeinrichtung (171, 172) im Zuluftkanal (140) zwischen der Lüftereinrichtung (150) und dem Lufteinlass (120) angeordnet ist.

11. Gebäude (100) nach einem der drei vorhergehenden Ansprüche,
**dadurch gekennzeichnet, dass** die Fremdstoffauffangeinrichtung (171, 172) ein im Wesentlichen horizontal angeordnetes Gitter (171) aufweist.

12. Gebäude (100) nach einem der vorhergehenden Ansprüche 8 bis 11, **dadurch gekennzeichnet, dass** die Fremdstoffauffangeinrichtung (171, 172) eine Sammeleinrichtung (172) aufweist, die ausgebildet ist, eingetretene Fremdstoffe zurückzuhalten, und vorzugsweise unterhalb des Gitters (171) angeordnet ist.

13. Gebäude (100) nach einem der beiden vorhergehenden Ansprüche, **dadurch gekennzeichnet, dass** die Sammeleinrichtung (172) ganz oder abschnittsweise unterhalb der Lüftervorrichtung (150) angeordnet ist.

14. Gebäude (100) nach einem der vorhergehenden Ansprüche,
**gekennzeichnet durch** mindestens ein Luftleitblech, das derart angeordnet ist, dass es die Luftströmung vom Lufteinlass (120) zum Luftauslass (130) unterstützt.

15. Gebäude (100) nach einem der vorhergehenden Ansprüche 8 bis 14, **gekennzeichnet durch** mindestens ein Prallblech, das derart angeordnet ist, dass es eine Leitung von Fremdstoffen in Richtung der Fremdstoffauffangeinrichtung (171, 172) unterstützt.
